# EUROPEAN PATENT APPLICATION

(11) **EP 4 141 318 A1**
(43) Date of publication of application: **01.03.2023**
(21) Application number: 21793086.6
(22) Date of filing: 20.04.2021
(51) Int. Cl.: F21V 8/00, F21Y 113/13, F21Y 115/10, F21Y 115/30, F21S 2/00, F21V 9/30, G02B 6/02, G02B 6/42, G02B 6/44, H01S 3/00, H01S 3/067, H01S 3/10

(54) **ILLUMINATION SYSTEM**

(30) Priority: 24.04.2020 JP 2020077828
(71) Applicant: Panasonic Intellectual Property Management Co., Ltd., Osaka-shi, Osaka 540-6207 (JP)
(72) Inventor: NANAI, Norishige, Chuo-ku, Osaka-shi, Osaka 540-6207 (JP); MIZOKAMI, Yosuke, Chuo-ku, Osaka-shi, Osaka 540-6207 (JP); SATO, Toshihiko, Chuo-ku, Osaka-shi, Osaka 540-6207 (JP)
(74) Representative: Müller-Boré & Partner Patentanwälte PartG mbB
(86) International application number: PCT/JP2021/016014
(87) International publication number: WO 2021/215433

(57) **Abstract**

Disclosed herein is a technique for increasing the intensity of light having a different wavelength from excitation light. A lighting system (1) includes an optical fiber (2), a first light source unit (11), a second light source unit (12), and a lighting unit (6). The optical fiber (2) includes a light incident portion (21), a light emerging portion (22), and a wavelength-converting portion (23). The wavelength-converting portion (23) is provided between the light incident portion (21) and the light emerging portion (22). The wavelength-converting portion (23) contains a wavelength-converting element which is excited by excitation light and amplifies a spontaneous emission of light, having a longer wavelength than the excitation light, with an amplified spontaneous emission of light. The first light source unit (11) makes the excitation light (P1) incident on the light incident portion (21). The second light source unit (12) makes seed light (P2), which causes the wavelength-converting element excited by the excitation light (P1) and the amplified spontaneous emission of light to produce a stimulated emission of light, incident on the light incident portion (21). The lighting unit (6) projects, into an external space (S1), light emerging from the light emerging portion (22) of the optical fiber (2).

## Description

### Technical Field

The present disclosure generally relates to a lighting system, and more particularly relates to a lighting system including an optical fiber.

### Background Art

A lighting fixture including a case, a projection lens, and a light source device has been proposed in the art (see, for example, Patent Literature 1). The light source device disclosed in Patent Literature 1 includes a solid-state light source and a light transmission fiber. The light transmission fiber has a first end face and a second end face, and excitation light emitted from the solid-state light source is introduced into the fiber through the first end face thereof. The light transmission fiber includes a wavelength-converting core, a light-guiding core, and a clad. The wavelength-converting core contains a wavelength-converting material that produces a population inversion state of electrons by absorbing the excitation light and that lets wavelength-converted light, falling within the visible radiation range, emerge therefrom. The light-guiding core covers the peripheral surface of the wavelength-converting core and transmits the wavelength-converted light in a direction from the first end face toward the second end face. The clad covers the peripheral surface of the light-guiding core.

The light transmission fiber is configured to have a stimulated emission produced by the wavelength-converted light propagating through the light-guiding core and to let not only the excitation light, emitted from the solid-state light source, but also the wavelength-converted light, amplified by the stimulated emission, emerge from the second end face.

It is difficult for the lighting fixture of Patent Literature 1 to increase the intensity of the wavelength-converted light.

### Citation List

### Patent Literature

Patent Literature 1: JP 2018-195627 A

### Summary of Invention

It is therefore an object of the present disclosure to provide a lighting system with the ability to increase the intensity of light having a different wavelength from excitation light.

A lighting system according to an aspect of the present disclosure includes an optical fiber, a first light source unit, a second light source unit, and a lighting unit. The optical fiber includes a light incident portion, a light emerging portion, and a wavelength-converting portion. The wavelength-converting portion is provided between the light incident portion and the light emerging portion. The wavelength-converting portion contains a wavelength-converting element. The wavelength-converting element is excited by excitation light and amplifies a spontaneous emission of light, having a longer wavelength than the excitation light, with an amplified spontaneous emission of light. The first light source unit makes the excitation light incident on the light incident portion. The second light source unit makes seed light incident on the light incident portion. The seed light causes the wavelength-converting element that has been excited by the excitation light and the amplified spontaneous emission of light to produce a stimulated emission of light. The lighting unit projects, into an external space, light emerging from the light emerging portion of the optical fiber.

### Brief Description of Drawings

FIG. 1 illustrates a configuration for a lighting system according to a first embodiment;
FIG. 2A is a cross-sectional view of a first end of an optical fiber in the lighting system;
FIG. 2B is a cross-sectional view of a second end of an optical fiber in the lighting system;
FIGS. 3A-3C illustrate an operating principle of the lighting system;
FIG. 4 illustrates a configuration for a lighting system according to a variation of the first embodiment;
FIG. 5 illustrates a configuration for a lighting system according to a second embodiment;
FIG. 6 illustrates a configuration for a lighting system according to a third embodiment;
FIG. 7 illustrates a configuration for a lighting system according to a fourth embodiment;
FIG. 8 illustrates a configuration for a lighting system according to a fifth embodiment;
FIG. 9 illustrates a configuration for a lighting system according to a sixth embodiment;
FIG. 10 is a block diagram of the lighting system;
FIG. 11A illustrates a configuration for a lighting unit included in the lighting system;
FIG. 11B is a bottom view of a frame member of the lighting unit included in the lighting system;
FIGS. 12A and 12B illustrate how the lighting system operates;
FIGS. 13A and 13B illustrate how the lighting system operates;
FIGS. 14A and 14B illustrate a lighting unit included in a lighting system according to a first variation of the sixth embodiment; and
FIG. 15 illustrates a lighting unit included in a lighting system according to a second variation of the sixth embodiment.

### Description of Embodiments

The drawings to be referred to in the following description of first to sixth embodiments are all schematic representations. That is to say, the ratio of the dimensions (including thicknesses) of respective constituent elements illustrated on the drawings does not always reflect their actual dimensional ratio.

### (First embodiment)

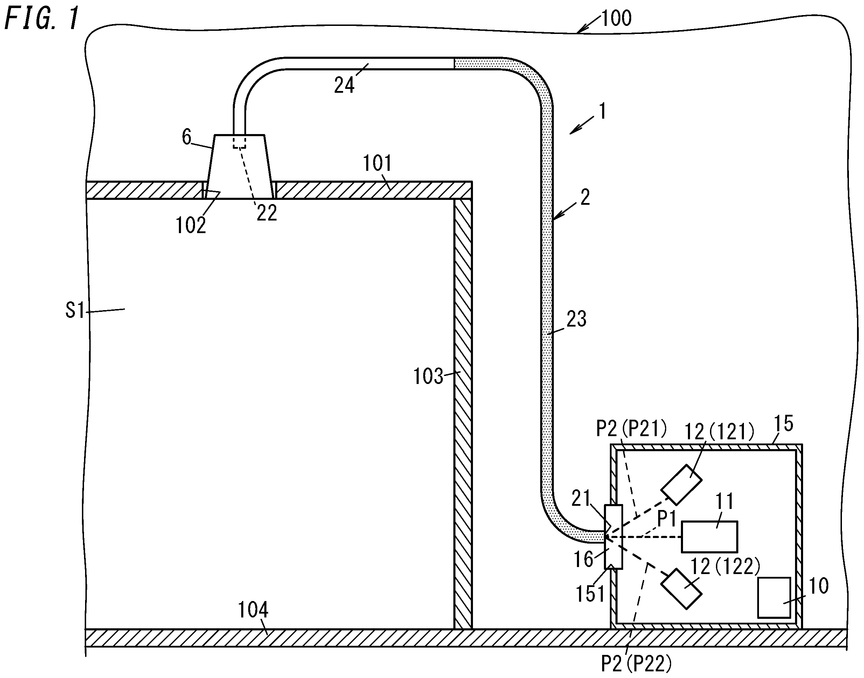

A lighting system 1 according to a first embodiment will be described with reference to FIGS. 1-3C.

### (1) Overview

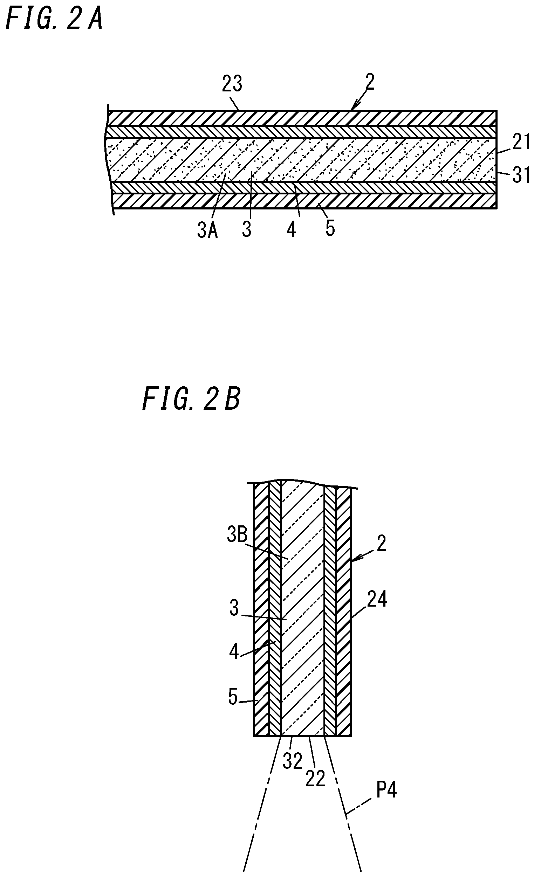

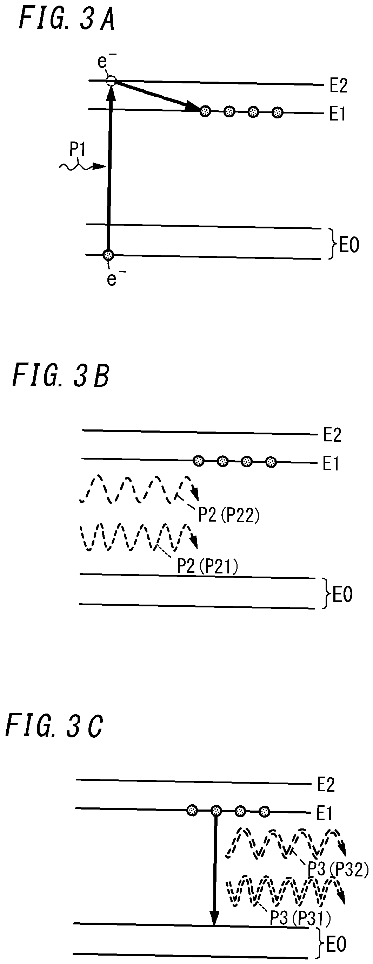

The lighting system 1 makes excitation light P1 and seed light P2 incident on an optical fiber 2 to which a wavelength-converting element (chemical element) is added as shown in FIGS. 1 and 2A. The excitation light P1 excites the wavelength-converting element. The seed light P2 causes the wavelength-converting element that has been excited by the excitation light P1 to produce a stimulated emission of light P3 (see FIG. 3C). As shown in FIGS. 1 and 2B, from the optical fiber 2, light P4 including the excitation light P1 and the stimulated emission of light P3 emerges. FIGS. 3A-3C illustrate the principle of operation of the lighting system 1. In FIGS. 3A, 3B, and 3C, the ordinate represents the energy of electrons. The upward arrow shown in FIG. 3A indicates absorption of the excitation light P1. The downward arrow shown in FIG. 3C indicates transition about a spontaneous emission of light or a stimulated emission of light P3. In the lighting system 1, an electron e⁻ in a ground state E0 (including a plurality of energy levels) of the wavelength-converting element is excited to an excitation level E2 by the excitation light P1 that has been incident on the optical fiber 2. Then, the electron e⁻ at the excitation level E2 makes a transition to a metastable level E1, which is an energy level lower than the excitation level E2. Thereafter, the stimulated emission of light P3 (P32) is produced when the electron e⁻ at the metastable level E1 is caused to make a transition to one of the highest ones of the plurality of energy levels (hereinafter referred to as a "second energy level") of the ground state E0 by the seed light P2 (P22), of which the wavelength corresponds to the difference in energy between the metastable level E1 and the second energy level, for example. In addition, a stimulated emission of light P3 (P31) is also produced when the electron e⁻ at the metastable level E1 is caused to make a transition to another energy level (hereinafter referred to as a "first energy level"), lower than the second energy level out of the plurality of energy levels of the ground state E0, by the seed light P2 (P21), of which the wavelength corresponds to the difference in energy between the metastable level E1 and the first energy level.

The lighting system 1 may be used as a down light, for example. However, this is only an example and should not be construed as limiting. The lighting system 1 may be applied to a facility or a moving vehicle, whichever is appropriate. Examples of facilities to which the lighting system 1 is applicable include tennis courts, athletic stadiums, airports, single-family dwelling houses, multi-family dwelling houses, office buildings, stores, art museums, hotels, and factories. Examples of moving vehicles to which the lighting system 1 is applicable include automobiles, bicycles, railway trains, aircrafts, watercrafts, and drones.

### (2) Configuration for lighting system

The lighting system 1 includes the optical fiber 2, a first light source unit 11, a second light source unit 12, and a lighting unit 6 as shown in FIG. 1. The first light source unit 11 makes the excitation light P1 incident on a light incident portion 21. The second light source unit 12 makes the seed light P2, which causes the wavelength-converting element excited by the excitation light P1 to produce the stimulated emission of light P3 (hereinafter referred to as "external seed light P2"), incident on the light incident portion 21.

### (2.1) Optical fiber

The optical fiber 2 includes a core 3, a clad 4, and a coating portion 5 as shown in FIGS. 2A and 2B. The clad 4 covers the outer peripheral surface of the core 3. The coating portion 5 covers the outer peripheral surface of the clad 4. A cross section, taken along a plane perpendicular to the optical axis, of the core 3 has a circular shape. The clad 4 is disposed coaxially with the core 3.

The core 3 has a first end face 31 (see FIG. 2A) and a second end face 32 (see FIG. 2B), which is located at the opposite longitudinal end of the core 3 from the first end face 31. The core 3 includes a first core portion 3A and a second core portion 3B. The first core portion 3A and the second core portion 3B are each shorter in length than the core 3. The length of the core 3 is the sum of the length of the first core portion 3A and the length of the second core portion 3B. The first core portion 3A includes the first end face 31 but does not include the second end face 32. The second core portion 3B includes the second end face 32 but does not include the first end face 31. The first core portion 3A contains a light-transmitting material and the wavelength-converting element. The second core portion 3B contains the light-transmitting material but does not contain the wavelength-converting element. The concentration of the wavelength-converting element in the first core portion 3A may or may not be uniform along the entire length of the first core portion 3A. The refractive index of the core 3 may be substantially equal to the refractive index of the light-transmitting material that is a main component of the core 3.

The light-transmitting material may be, for example, a fluoride, an oxide, or a nitride. The fluoride may be glass fluoride, for example. The oxide may be a silicon oxide or quartz, for example.

The wavelength-converting element is a rare earth element. In this embodiment, the wavelength-converting element includes an element selected from the group consisting of, for example, Pr, Tb, Ho, Dy, Er, Eu, Nd, and Mn. The wavelength-converting element is contained as an ion of a rare earth element in the core 3, e.g., contained as an ion of Pr (Pr³⁺) or an ion of Tb (Tb³⁺) in the core 3. In this case, the wavelength-converting element may be excited by either the excitation light P1 or an amplified spontaneous emission (ASE) of light. The amplified spontaneous emission (ASE) of light is produced by amplifying the spontaneous emission of light, emitted from a different wavelength-converting element other than the wavelength-converting elements itself, as internal seed light. Through such excitation, the wavelength-converting element emits not only an ASE unique to the element of the wavelength-converting element but also a stimulated emission of light having the same wavelength as the external seed light P2, thus emitting them as the stimulated emission of light P3. The wavelengths of the ASE and the external seed light P2 are longer than the wavelength of the excitation light P1 (which may fall within the range from 440 nm to 450 nm, for example). The wavelength of the seed light P2 will be described later in the "(2.3) Second light source unit" section.

Pr³⁺ is a wavelength-converting element that may emit either an ASE or amplified seed light in the cyan to red range. The intensity of the stimulated emission of light depends on the respective intensities of the internal seed light (the spontaneous emission of light) and the external seed light. If the core 3 contains Pr³⁺ and Tb³⁺, then Tb³⁺ is excited by absorbing an ASE from Pr³⁺ and may produce an ASE having a wavelength unique to Tb³⁺.

The refractive index of the clad 4 is less than the refractive index of the core 3. The clad 4 does not contain the wavelength-converting element contained in the (first core portion 3A of the) core 3.

The material of the coating portion 5 may be a resin, for example.

The optical fiber 2 includes the light incident portion 21, a light emerging portion 22, and a wavelength-converting portion 23.

The light incident portion 21 is a portion on which the excitation light P1 is incident and may include the first end face 31 of the core 3, for example. The light emerging portion 22 includes the second end face 32 of the core 3, through which light P4 including the excitation light P1 and the stimulated emission of light P3 such as an ASE emerges.

The light incident portion 21 may include a reflection reducing portion for reducing the reflection of the excitation light P1 incident on the light incident portion 21 from outside of the optical fiber 2. The reflection reducing portion may be, for example, an anti-reflection coating that covers the first end face 31 of the core 3.

The light emerging portion 22 may include a reflection reducing portion for reducing reflection of the excitation light P1 and the stimulated emission of light P3 including an ASE. The reflection reducing portion is preferably made of a transparent material, of which the refractive index is substantially equal to that of the core 3, for example. The reflection reducing portion includes an end cap, for example. Providing the reflection reducing portion for the light emerging portion 22 allows the optical fiber 2 to reduce an increase in the electric field strength due to reflection from the second end face 32 of the core 3 and also protect the second end face 32 of the core 3 from damage. In the optical fiber 2, if the second end face 32 of the core 3 is in contact with the air, a Fresnel reflection of a few % could be caused at the second end face 32, thus possibly causing parasitic oscillation that makes it difficult to control the optical output. To reduce the Fresnel reflection, the optical fiber 2 preferably includes the reflection reducing portion bonded to the second end face 32 of the core 3. The material for the reflection reducing portion may also be glass fluoride, silicon oxide, or quartz, for example. The light emerging portion 22 may have a tilted surface which is tilted by a predetermined angle (of 8 degrees, for example) with respect to a plane intersecting at right angles with the optical axis of the optical fiber 2. This enables, even if there is a refractive index difference between the reflection reducing portion and the core 3, the optical fiber 2 to reduce components of light reflected back from the boundary between the second end face 32 and the reflection reducing portion to the first end face 31 (i.e., back reflected components), thus causing an increase in the efficiency of the light emerging from the light emerging portion 22. The predetermined angle does not have to be 8 degrees. When measured along the optical axis of the optical fiber 2, the length of the end cap may fall within the range from 100 µm to 3 mm, for example. In this embodiment, the end cap is disposed over both the core 3 and the clad 4. However, this is only an example and should not be construed as limiting. Rather, the end cap only needs to be disposed on the second end face 32 of the core 3. The reflection reducing portion does not have to be the end cap but may also be, for example, a microscopic surface unevenness (on the order of 200 nm or less) formed on the second end face 32 of the core 3. In that case, the end cap may or may not be provided from the viewpoint of reflection reduction.

The wavelength-converting portion 23 is provided between the light incident portion 21 and the light emerging portion 22. The wavelength-converting portion 23 contains a wavelength-converting element which is excited by the excitation light P1 to emit light having a longer wavelength than the excitation light P1. The wavelength-converting element is an element that may absorb the excitation light P1 and amplify, by stimulated emission, either the spontaneous emission of light or seed light having a longer wavelength than the excitation light P1. The wavelength-converting portion 23 includes: the first core portion 3A of the core 3; a part, corresponding to the first core portion 3A, of the clad 4 (i.e., its part covering the outer peripheral surface of the first core portion 3A); and a part, corresponding to the first core portion 3A, of the covering portion 5. In FIG. 1, the wavelength-converting portion 23 of the optical fiber 2 and the rest 24 of the optical fiber 2 other than the wavelength-converting portion 23 may be distinguished from each other by dotted hatching. Specifically, in FIG. 1, the wavelength-converting portion 23 of the optical fiber 2 is indicated by dotted hatching and the rest 24 of the optical fiber 2 other than the wavelength-converting portion 23 is not shared by dotted hatching. The light-transmitting material of the first core portion 3A is preferably the same as the light-transmitting material of the second core portion 3B. The refractive index of the first core portion 3A is preferably equal to the refractive index of the second core portion 3B.

The core 3 may have a diameter falling within the range from 25 µm to 500 µm, for example. The optical fiber 2 may have a length falling within the range from 3 m to 10 m, for example. As for the length of the wavelength-converting portion 23, the lower the concentration of the wavelength-converting element in the wavelength-converting portion 23 is, the greater the length of the wavelength-converting portion 23 preferably is. The optical fiber 2 may have a numerical aperture of 0.22, for example. The concentration of the wavelength-converting element in the wavelength-converting portion 23 is the concentration of the wavelength-converting element in the first core portion 3A.

### (2.2) First light source unit

The first light source unit 11 emits the excitation light P1 to excite the wavelength-converting element contained in the wavelength-converting portion 23 of the optical fiber 2. The excitation light P1 emitted from the first light source unit 11 is incident on the light incident portion 21 of the optical fiber 2.

The first light source unit 11 may include a laser light source, for example. The laser light source emits a laser beam. The excitation light P1 emitted from the first light source unit 11 (i.e., the laser beam emitted from the laser light source) is incident on the light incident portion 21. The laser light source may be, for example, a semiconductor laser diode that emits a blue laser beam. In that case, the excitation light P1 may have a wavelength falling within the range from 440 nm to 450 nm, for example.

### (2.3) Second light source unit

The second light source unit 12 emits the seed light P2. The seed light P2 emitted from the second light source unit 12 is incident on the light incident portion 21 of the optical fiber 2.

The lighting system 1 includes a plurality of (e.g., two) second light source units 12, each of which emits, for example, seed light P2 having a single wavelength. The seed light P2 emitted from one of these two second light source units 12 has a different wavelength from the seed light P2 emitted from the other of these two second light source units 12. In the following description, one of the two second light source units 12 will be hereinafter referred to as a "second light source unit 121" and the other second light source unit 12 will be hereinafter referred to as a "second light source unit 122" for convenience sake. The second light source unit 121 may be a semiconductor laser diode that emits a green light ray, for example. The second light source unit 122 may be a semiconductor laser diode that emits a red light ray, for example. If the wavelength-converting element of the wavelength-converting portion 23 includes Pr³⁺, then the wavelength of the green seed light ray P21 is preferably about 520 nm, for example, and the wavelength of the red seed light ray P22 is preferably about 640 nm, for example. These second light source units 12 are light sources, each of which emits quasi-monochromatic light. As used herein, the "quasi-monochromatic light" refers to light falling within a narrow wavelength range (with a width of 10 nm, for example). The number of the second light source units 12 included in the lighting system 1 does not have to be two but may also be three or more or even one. If the lighting system 1 includes three second light source units 12, then the lighting system 1 may include, as the three second light source units 12, a semiconductor laser diode that emits a green light ray, a semiconductor laser diode that emits a red light ray, and a semiconductor laser diode that emits an orange light ray. The orange seed light ray preferably has a wavelength of about 600 nm, for example.

The light emitted from the second light source unit 121 is incident as a seed light ray P2 (P21) on the light incident portion 21 of the optical fiber 2. The light emitted from the second light source unit 122 is incident as a seed light ray P2 (P22) on the light incident portion 21 of the optical fiber 2.

### (2.4) Lighting unit

The lighting unit 6 projects, into the external space S1, the light emerging from the light emerging portion 22 of the optical fiber 2. The lighting unit 6 holds the light emerging portion 22 of the optical fiber 2 thereon. The lighting unit 6 may include an optical member for controlling the distribution of the light emerging from the light emerging portion 22 of the optical fiber 2. The optical member may be, for example, a lens or a reflector. If the lighting system 1 is used as a down light, then the lighting unit 6 may be fitted into a through hole 102 of the ceiling 101 of a building 100, for example. In that case, part of the optical fiber 2 will be hidden behind the ceiling 101 and a wall 103 of the building 100, which form a structure for holding the lighting unit 6. In other words, part of the optical fiber 2 is installed on the back of the ceiling and the wall. The lighting unit 6 may be mounted to the ceiling 101 with, for example, a flange protruding outward from the bottom of the lighting unit 6 and a plurality of leaf springs to clamp the ceiling 101 between the flange and themselves. Alternatively, the lighting unit 6 may also be mounted onto the ceiling 101 with, for example, a mounting bracket and a plurality of mounting springs.

### (2.5) Other constituent elements

The lighting system 1 includes a housing 15 to house the first light source unit 11 and the plurality of second light source units 12 therein. The housing 15 may be installed, for example, on the floor 104 of the building 100 and behind the wall 103.

The lighting system 1 further includes an adjustment unit 10. The adjustment unit 10 adjusts the intensity of the seed light P2 having at least one wavelength. In the lighting system 1 according to the first embodiment, the adjustment unit 10 adjusts the intensity of the excitation light P1 and the respective intensities of seed light rays P21, P22. The adjustment unit 10 includes: a first driver circuit for driving the first light source unit 11; a plurality of second driver circuits, which are provided one to one for the plurality of second light source units 12 and each of which drives a corresponding one of the second light source units 12; and a control circuit for controlling the first driver circuit and the plurality of second driver circuits on an individual basis. In the adjustment unit 10, the control circuit controls the first driver circuit and the plurality of second driver circuits on an individual basis, thus making the chromaticity of the light P4 emerging from the light emerging portion 22 of the optical fiber 2 adjustable. In short, the lighting system 1 includes the adjustment unit 10, thus enabling controlling the color of the emerging light. In this embodiment, the adjustment unit 10 is housed in the housing 15. However, this is only an example and the adjustment unit 10 does not have to be housed in the housing 15. The first driver circuit and the plurality of second driver circuits are supplied with supply voltage from a first power supply circuit, for example. Meanwhile, the control circuit is supplied with supply voltage from a second power supply circuit, for example. In this embodiment, the first power supply circuit and the second power supply circuit are not counted among the constituent elements of the lighting system 1. However, this is only an example and should not be construed as limiting. Alternatively, the first power supply circuit and the second power supply circuit may be counted among constituent elements of the lighting system 1.

The lighting system 1 further includes a photocoupler 16 to make the excitation light P1 and the respective seed light rays P2 incident on the light incident portion 21 of the optical fiber 2. The photocoupler 16 is disposed at an opening 151 of the housing 15. The photocoupler 16 may be, but does not have to be, a waveguide coupler. Alternatively, the photocoupler 16 may also be an optical fiber coupler, or any other multi-wavelength combiner. A material for the waveguide coupler, the optical fiber coupler, and the multi-wavelength combiner may be, but does not have to be, quartz, for example. Optionally, in this lighting system 1, the photocoupler 16 may include a lens and the lens of the photocoupler 16, which is arranged to receive the excitation light P1, may also receive the seed light P2. If the first light source unit 11 and the second light source unit 12 are each configured to let the excitation light P1 and the seed light P2 emerge through the optical fiber, then the respective optical fibers may be arranged such that the light emerging from each of the optical fibers is introduced into the photocoupler 16. Optionally, the light (including the excitation light P1 and the respective seed light rays P2) incident on the light incident portion 21 of the optical fiber 2 may be adjusted by using a lens, a mirror, a prism, an optical member with a slit that passes light, and other optical members. Adjustments using these optical members may be combined as appropriate even when the first light source unit 11 or the second light source unit 12 lets the light emerge through the optical fiber. Optionally, part of the photocoupler 16, through which the excitation light P1 or the seed light P2 is introduced, may include a reflection reducing portion. The reflection reducing portion may be, for example, an anti-reflection coating.

### (3) Operation of lighting system

The lighting system 1 makes the first light source unit 11 emit the excitation light P1 and also makes the plurality of second light source units 12 emit the seed light rays P21, P22, respectively. Thus, the lighting system 1 allows the excitation light P1 and the seed light P2 to be incident on the light incident portion 21 of the optical fiber 2. Part of the excitation light P1 incident on the light incident portion 21 emerges from the light emerging portion 22. In the lighting system 1, the light P4 emerging from the light emerging portion 22 of the optical fiber 2 is mixed light in which the excitation light P1, an ASE with a wavelength of about 480 nm and produced from the wavelength-converting element, and the light produced by amplifying the seed light P2 are mixed together. Two types of stimulated emissions of light P31, P32 corresponding one to one to the multiple seed light rays P21, P22 and having mutually different wavelengths may be, for example, a green ray and a red ray, respectively. In that case, the mixed light may be white light, for example. In FIG. 3C, the lower stimulated emission of light P3 (P31) is the green ray and the upper stimulated emission of light P3 (P32) is the red ray.

In the optical fiber 2, stimulated emission is produced by the spontaneous emission of light and the seed light P2, and therefore, the excitation light P1 incident on the light incident portion 21 and the stimulated emission of light P3 amplified by stimulated emission emerge from the light emerging portion 22. The stimulated emission of light P3 having the same wavelength as the seed light ray P21 of the light P4 emerging from the light emerging portion 22 of the optical fiber 2 has a higher intensity than the seed light ray P21 incident from the second light source unit 121 onto the light incident portion 21. Also, the stimulated emission of light P3 having the same wavelength as the seed light ray P22 of the light P4 emerging from the light emerging portion 22 of the optical fiber 2 has a higher intensity than the seed light ray P22 incident from the second light source unit 122 onto the light incident portion 21. The mixed light emerging from the light emerging portion 22 of the optical fiber 2 is incoherent light. In the lighting system 1, the chromaticity, color temperature, color rendering index, and other parameters of the light P4 emerging from the light emerging portion 22 of the optical fiber 2 are determined by the respective wavelengths of the ASE and the seed light P2. Note that the operation of the lighting system 1 is different from the operation of a fiber laser that produces laser oscillation.

In the lighting system 1, the wavelength-converting element that serves as a heat source is distributed in the core 3 of the optical fiber 2, and therefore, an increase in temperature may be reduced while the lighting system 1 is being used.

Also, in the lighting system 1, the adjustment unit 10 adjusts the intensity of the excitation light P1 and the respective intensities of the multiple seed light rays P2. However, this is only an example and should not be construed as limiting. Alternatively, the adjustment unit 10 may also be configured to adjust the intensity of the seed light P2 having at least one wavelength.

### (4) Recapitulation

A lighting system 1 according to the first embodiment includes an optical fiber 2, a first light source unit 11, a second light source unit 12, and a lighting unit 6. The optical fiber 2 includes a light incident portion 21, a light emerging portion 22, and a wavelength-converting portion 23. The wavelength-converting portion 23 is provided between the light incident portion 21 and the light emerging portion 22. The wavelength-converting portion 23 contains a wavelength-converting element, which is excited by excitation light P1 and amplifies a spontaneous emission of light, having a longer wavelength than the excitation light P1, with an amplified spontaneous emission of light (i.e., a stimulated emission). The first light source unit 11 makes the excitation light P1 incident on the light incident portion 21. The second light source unit 12 makes seed light P2 incident on the light incident portion 21. The seed light P2 causes the wavelength-converting element that has been excited by the excitation light P1 and the amplified spontaneous emission of light to produce a stimulated emission of light P3. The lighting unit 6 projects, into an external space S1, light P4 emerging from the light emerging portion 22 of the optical fiber 2.

The lighting system 1 according to the first embodiment enables increasing the intensity of light (i.e., the stimulated emission of light P3) having a different wavelength from the excitation light P1.

In addition, in the lighting system 1 according to the first embodiment, the wavelength-converting portion 23 is provided between the light incident portion 21 and the light emerging portion 22 of the optical fiber 2. This enables reducing an increase in the temperature of the wavelength-converting portion 23 by increasing the length of the wavelength-converting portion 23.

Furthermore, in the lighting system 1 according to the first embodiment, there are no heat generation sources such as the first light source unit 11, the second light source unit 12, and the wavelength-converting portion 23 in the lighting unit 6. This eliminates the need to provide any heat dissipating member for the lighting unit 6, thus contributing to reducing the size and weight of the lighting unit 6. Consequently, this makes it easier to install the lighting unit 6 on the ceiling 101, for example.

Furthermore, the lighting system 1 according to the first embodiment further includes an adjustment unit 10 for adjusting the respective intensities of multiple seed light rays P2 having multiple different wavelengths, thus making the chromaticity of the light P4 emerging from the light emerging portion 22 of the optical fiber 2 adjustable.

In addition, in the lighting system 1 according to the first embodiment, the wavelength-converting portion 23 contains Pr³⁺ as the wavelength-converting element. The wavelength-converting element not only emits an ASE in cyan but also increases the respective intensities of stimulated emissions in green and red, because a plurality of seed light rays P2 with mutually different wavelengths are incident onto the light incident portion 21. This allows the lighting system 1 according to the first embodiment to improve the color rendering index of the light P4 emerging from the light emerging portion 22 of the optical fiber 2. Furthermore, in the lighting system 1 according to the first embodiment, the wavelength-converting portion 23 contains Pr³⁺ and Tb³⁺ as two types of wavelength-converting elements, thus enabling further improving the color rendering index of the light P4 emerging from the light emerging portion 22 of the optical fiber 2.

### (Variation of first embodiment)

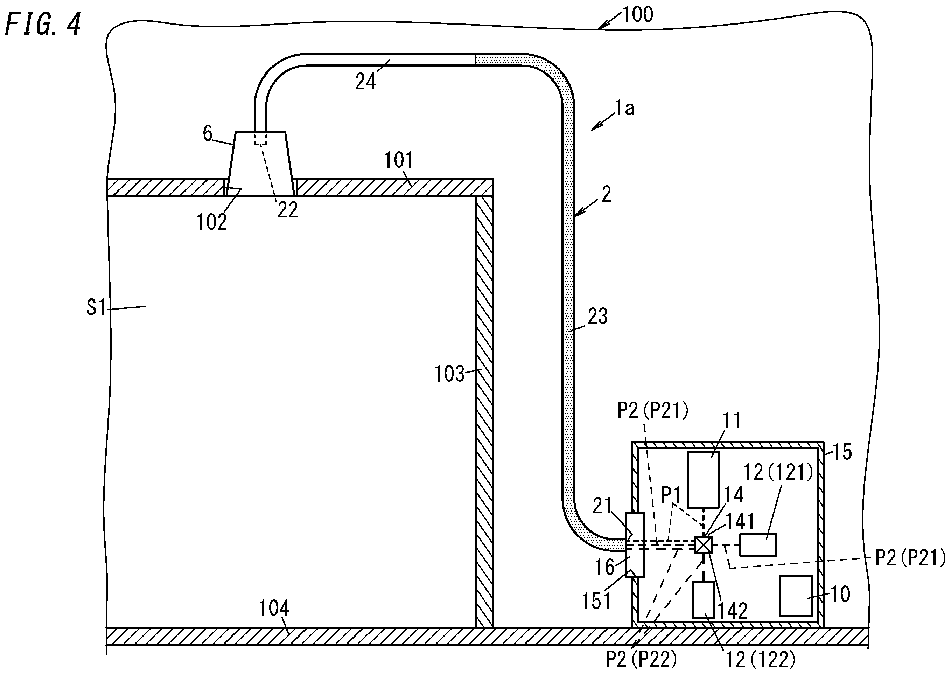

Next, a lighting system 1a according to a variation of the first embodiment will be described with reference to FIG. 4. In the following description, any constituent element of the lighting system 1a according to this variation, having the same function as a counterpart of the lighting system 1 according to the first embodiment described above, will be designated by the same reference numeral as that counterpart's, and description thereof will be omitted herein.

In the lighting system 1a according to this variation, the first light source unit 11 and the two second light source units 12 are arranged differently from in the lighting system 1 according to the first embodiment and a cross dichroic prism 14 is further provided, which are differences from the lighting system 1 according to the first embodiment.

The cross dichroic prism 14 is arranged to make the excitation light P1 coming from the first light source unit 11 and the two seed light rays P21, P22 respectively coming from the two second light source units 12 incident on the light incident portion 21 of the optical fiber 2.

The cross dichroic prism 14 includes: a first film 141 which transmits the seed light ray P21 (e.g., a green light ray in this example) coming from the second light source unit 121 and the seed light ray P22 (e.g., a red light ray in this example) coming from the second light source unit 122 and reflects the excitation light P1 (e.g., a blur light ray in this example); and a second film 142 which transmits the excitation light P1 coming from the first light source unit 11 and the seed light ray P21 coming from the second light source unit 121 and reflects the seed light ray P22 coming from the second light source unit 122. The first film 141 and the second film 142 are arranged to intersect with each other at right angles. In this lighting system 1a, the second light source unit 121 faces the light incident portion 21 of the optical fiber 2 and the cross dichroic prism 14 is arranged on the optical axis of the second light source unit 121 to be located between the second light source unit 121 and the light incident portion 21 of the optical fiber 2. In addition, the first light source unit 11, the cross dichroic prism 14, and the second light source unit 122 are arranged side by side in a direction intersecting at right angles with the optical axis of the second light source unit 121 and intersecting with the first film 141 and the second film 142.

The lighting system 1a according to this variation enables, as well as the lighting system 1 according to the first embodiment, increasing the intensity of light (stimulated emission of light P3) having a different wavelength from the excitation light P1.

### (Second embodiment)

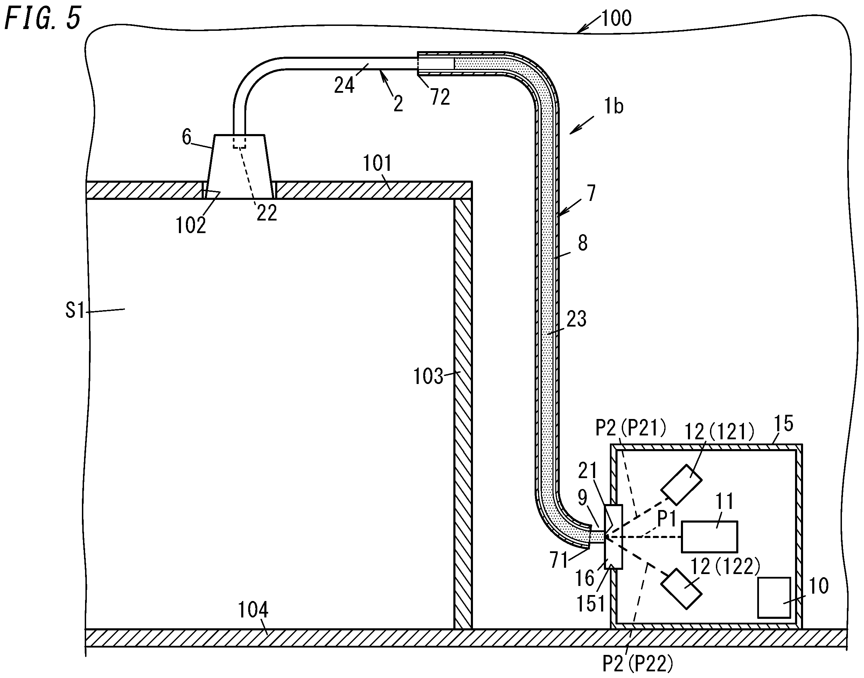

Next, a lighting system 1b according to a second embodiment will be described with reference to FIG. 5. In the following description, any constituent element of the lighting system 1b according to this second embodiment, having the same function as a counterpart of the lighting system 1 according to the first embodiment described above, will be designated by the same reference numeral as that counterpart's, and description thereof will be omitted herein.

The lighting system 1b according to the second embodiment further includes a protective cover 7, which is a difference from the lighting system 1 according to the first embodiment. The protective cover 7 covers the wavelength-converting portion 23 partially. In the lighting system 1b according to the second embodiment, a space 8 is left between the protective cover 7 and the wavelength-converting portion 23. The protective cover 7 has, along the longitudinal axis of the protective cover 7, a first end 71 and a second end 72 opposite from the first end 71. The protective cover 7 has a tubular shape and has a first opening at the first end 71 and a second opening at the second end 72. More specifically, the protective cover 7 has a circular tubular shape and has a circular first opening at the first end 71 and a circular second opening at the second end 72. The inside diameter of the first opening and the inside diameter of the second opening are greater than the outside diameter of the optical fiber 2. The space 8 communicates with the external space via the first opening and also communicates with the external space via the second opening. Note that the protective cover 7 does not have to have a circular tubular shape but may also have any other shape as long as a space 8 may be left between the inner peripheral surface of the protective cover 7 and the outer peripheral surface of the optical fiber 2. In that case, the first opening and the second opening may also have an elliptical or square shape, for example.

Providing the protective cover 7 for the lighting system 1b according to the second embodiment enables protecting at least a part of the wavelength-converting portion 23. In addition, the lighting system 1b according to the second embodiment has a space 8 between the protective cover 7 and the wavelength-converting portion 23, thus making it easier to dissipate the heat generated by the wavelength-converting portion 23.

In addition, in the lighting system 1b according to the second embodiment, a gap 9 is also left between the protective cover 7 and the first light source unit 11 and the second light source unit 12. More specifically, the lighting system 1b according to the second embodiment has the gap 9 between the first end 71 of the protective cover 7 and the photocoupler 16 and the gap 9 exposes one end, adjacent to the photocoupler 16, of the wavelength-converting portion 23. This makes it easier for the lighting system 1b according to the second embodiment to dissipate the heat generated by the wavelength-converting portion 23.

Furthermore, in the lighting system 1b according to the second embodiment, the protective cover 7 has flexibility. Thus, the lighting system 1b according to the second embodiment allows the optical fiber 2 and the protective cover 7 to be installed with an increased degree of freedom.

In the lighting system 1b according to this second embodiment, as well as the lighting system 1 according to the first embodiment, the wavelength-converting portion 23 also contains a wavelength-converting element, which is excited by excitation light P1 and amplifies a spontaneous emission of light, having a longer wavelength than the excitation light P1, with an amplified spontaneous emission of light (i.e., a stimulated emission). The first light source unit 11 makes the excitation light P1 incident on the light incident portion 21. The second light source unit 12 makes seed light P2 incident on the light incident portion 21. The seed light P2 causes the wavelength-converting element that has been excited by the excitation light P1 and the amplified spontaneous emission of light to produce a stimulated emission of light P3. The lighting unit 6 projects, into an external space S1, the light P4 (see FIG. 2B) emerging from the light emerging portion 22 of the optical fiber 2.

Thus, the lighting system 1b according to the second embodiment enables increasing the intensity of light (i.e., the stimulated emission of light P3) having a different wavelength from the excitation light P1.

### (Third embodiment)

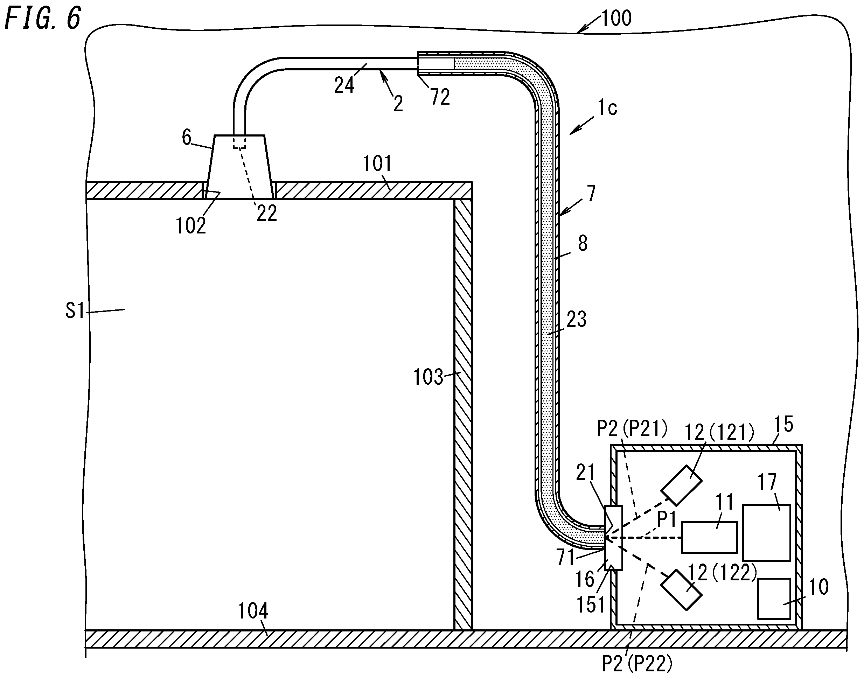

Next, a lighting system 1c according to a third embodiment will be described with reference to FIG. 6. In the following description, any constituent element of the lighting system 1c according to this third embodiment, having the same function as a counterpart of the lighting system 1b according to the second embodiment described above, will be designated by the same reference numeral as that counterpart's, and description thereof will be omitted herein.

In the lighting system 1c according to the third embodiment, the protective cover 7 is longer than the wavelength-converting portion 23 and covers the wavelength-converting portion 23 along the entire length thereof, which is a difference from the lighting system 1b according to the second embodiment.

The lighting system 1c according to this third embodiment allows the protective cover 7 to protect the wavelength-converting portion 23 in its entirety.

In addition, the lighting system 1c according to the third embodiment further includes a blower 17. The blower 17 is disposed inside the housing 15. The lighting system 1c according to the third embodiment includes the blower 17, and therefore, may cool the air inside the housing 15, thus enabling reducing an increase in the temperature of the first light source unit 11 and the plurality of second light source units 12. Also, if part of the air blown by the blower 17 is allowed to pass through the space 8 between the protective cover 7 and the wavelength-converting portion 23, then an increase in the temperature of the wavelength-converting portion 23 may be further reduced.

In the lighting system 1c according to this third embodiment, as well as the lighting system 1b according to the second embodiment, the wavelength-converting portion 23 also contains a wavelength-converting element, which is excited by excitation light P1 and amplifies a spontaneous emission of light, having a longer wavelength than the excitation light P1, with an amplified spontaneous emission of light (i.e., a stimulated emission). The first light source unit 11 makes the excitation light P1 incident on the light incident portion 21. The second light source unit 12 makes seed light P2 incident on the light incident portion 21. The seed light P2 causes the wavelength-converting element that has been excited by the excitation light P1 and the amplified spontaneous emission of light to produce a stimulated emission of light P3. The lighting unit 6 projects, into an external space S1, light P4 (see FIG. 2B) emerging from the light emerging portion 22 of the optical fiber 2.

Thus, the lighting system 1c according to the third embodiment enables increasing the intensity of light (i.e., the stimulated emission of light P3) having a different wavelength from the excitation light P1.

### (Fourth embodiment)

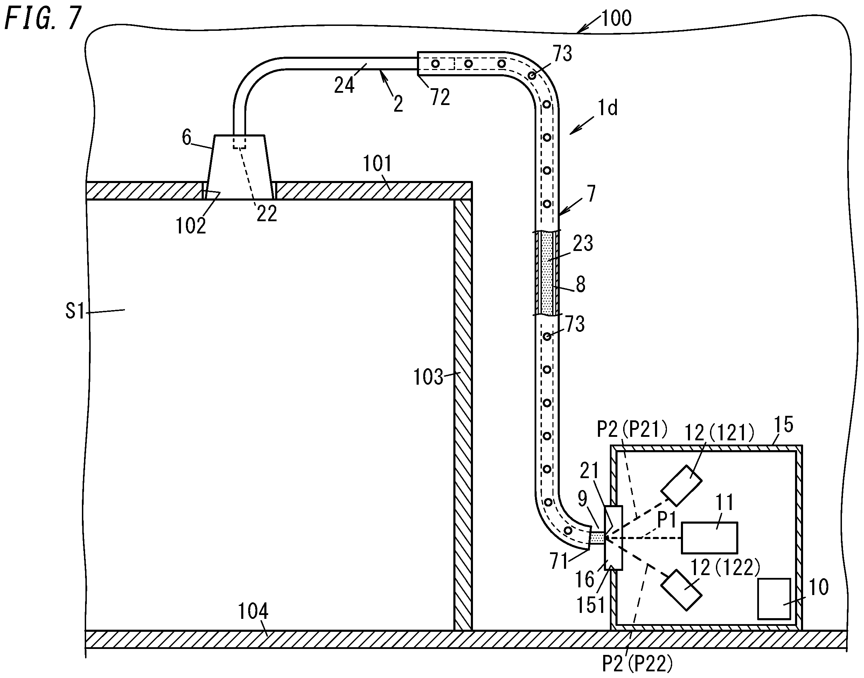

Next, a lighting system 1d according to a fourth embodiment will be described with reference to FIG. 7. In the following description, any constituent element of the lighting system 1d according to this fourth embodiment, having the same function as a counterpart of the lighting system 1b according to the second embodiment described above, will be designated by the same reference numeral as that counterpart's, and description thereof will be omitted herein.

In the lighting system 1d according to the fourth embodiment, the protective cover 7 has a plurality of through holes 73, which is a difference from the lighting system 1b according to the second embodiment. The plurality of through holes 73 communicate with the space 8 between the protective cover 7 and the wavelength-converting portion 23.

In the lighting system 1d according to the fourth embodiment, the protective cover 7 has the plurality of through holes 73, thus making it easier to dissipate the heat generated by the wavelength-converting portion 23 than in the lighting system 1b according to the second embodiment. The protective cover 7 may be, but does not have to be, made of a metal.

### (Fifth embodiment)

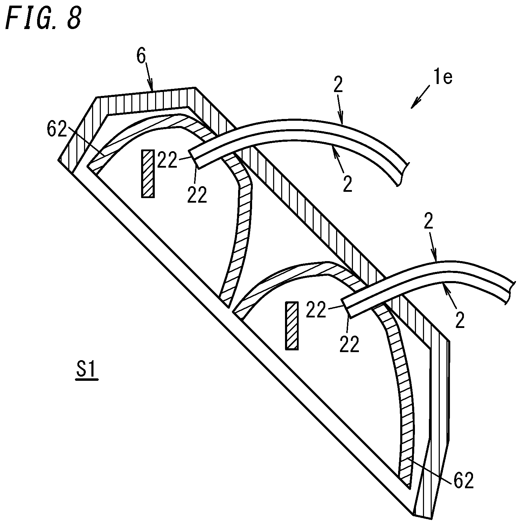

Next, a lighting system 1e according to a fifth embodiment will be described with reference to FIG. 8. In the following description, any constituent element of the lighting system 1e according to this fifth embodiment, having the same function as a counterpart of the lighting system 1 according to the first embodiment described above, will be designated by the same reference numeral as that counterpart's, and description thereof will be omitted herein. Note that in FIG. 8, illustration of the wavelength-converting portion 23, the first light source unit 11, the plurality of second light source units 12, and other members of the lighting system 1 according to the first embodiment is omitted.

The lighting system 1e according to this fifth embodiment is used as lighting for a tennis court, which is a difference from the lighting system 1 according to the first embodiment.

A lighting unit 6 included in the lighting system 1e according to the fifth embodiment is supported by a hollow pole provided to stand upright from the ground around the tennis court. The pole is a structure for supporting the lighting unit 6.

In the lighting system 1e according to the fifth embodiment, part of the optical fiber 2 is inserted into the pole. Thus, the wavelength-converting portion 23 is hidden behind the pole.

The lighting system 1e includes a plurality of (e.g., four in the example illustrated in FIG. 8) optical fibers 2. Two out of the plurality of (e.g., four in the example illustrated in FIG. 8) optical fibers 2 are bundled together and another two optical fibers 2 are also bundled together to form two bundles of optical fibers 2 that are held by the lighting unit 6. This allows the lighting system 1e to increase the quantity of light emerging from the lighting unit 6 while reducing an increase in the overall size of the lighting unit 6. Each bundle, out of the two or more bundles of optical fibers 2, is partially inserted into the pole.

In this lighting system 1e, the lighting unit 6 includes a lighting unit body 61 that holds the optical fibers 2 and reflectors 62. Each of the reflectors 62 reflects at least a part of the light P4 emerging from the respective light emerging portions 22 of its associated bundle of optical fibers 2 toward the external space S1. This allows the lighting system 1e to make the reflectors 62 control the distribution of the light. In this lighting system 1e, one reflector 62 is provided for one bundle of two optical fibers 2 and another reflector 62 is provided for another bundle of two optical fibers 2.

The number of the optical fibers 2 provided is not limited to any particular number as long as a plurality of optical fibers 2 are provided. For example, only two optical fibers 2 may be provided. In that case, the two optical fibers 2 only need to be bundled together and the lighting unit 6 may include only one reflector 62.

### (Sixth embodiment)

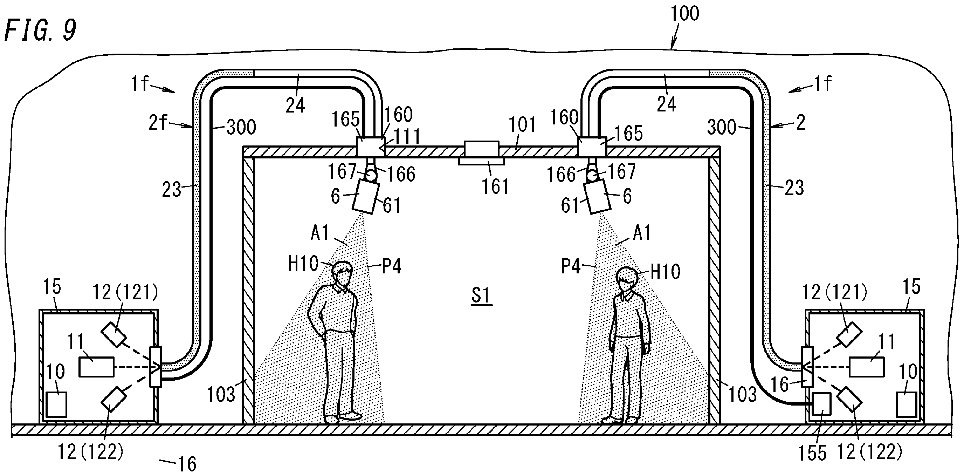

Next, a lighting system 1f according to a sixth embodiment will be described with reference to FIGS. 9-13B. In the following description, any constituent element of the lighting system 1f according to this sixth embodiment, having the same function as a counterpart of the lighting system 1 according to the first embodiment described above, will be designated by the same reference numeral as that counterpart's, and description thereof will be omitted herein.

As shown in FIG. 9, the lighting system 1f according to the sixth embodiment includes a supporting member 160 for supporting the lighting unit body 61 of each lighting unit 6. The supporting member 160 includes: a fixed portion 165 to be fixed onto the ceiling 101; a hollow arm 166 having a first end coupled to the fixed portion 165 and a second end; and a coupler 167 that couples the second end of the arm 166 to the lighting unit body 61 of the lighting unit 6. The fixed portion 165 is fixed onto the ceiling 101 with a part of the fixed portion 165 embedded in a mounting hole 111 provided through the ceiling 101. The fixed portion 165, the arm 166, and the coupler 167 have a space to pass the optical fiber 2 and a power cable 300 (to be described later) therethrough. The power cable 300 is connected to a power supply device 155 disposed in the housing 15. In this lighting system 1f, part of the optical fiber 2 and part of the power cable 300 are inserted into the fixed portion 165, the arm 166, and the coupler 167. Thus, the part of the optical fiber 2 and the part of the power cable 300 are hidden behind the fixed portion 165, the arm 166, and the coupler 167. The coupler 167 is a hinge device (rotary mechanism) for coupling the lighting unit 6 to the arm 166 to allow the lighting unit 6 to turn from a first position to a second position, or vice versa, around one rotational axis which intersects at right angles with the axis of the arm 166. More specifically, the coupler 167 is a hinge device that couples the lighting unit 6 to the arm 166 to allow the lighting unit 6 to rotate clockwise and counterclockwise in front view shown in FIG. 9. This lighting system 1f includes the coupler 167 serving as such a hinge device, and therefore, may adjust the irradiation direction of the light P4 emerging from the lighting unit 6.

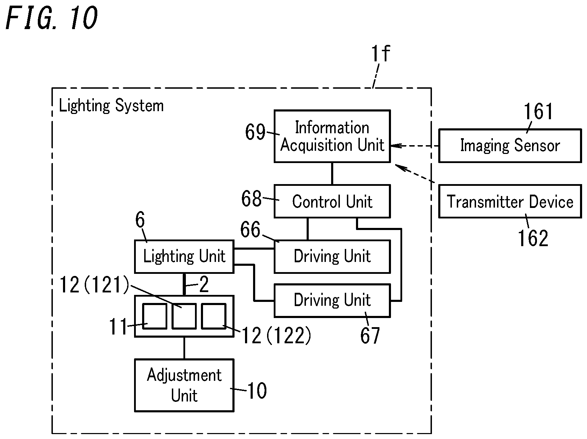

As shown in FIG. 10, the lighting system 1f further includes an information acquisition unit 69, a first driving unit 66, a second driving unit 67, and a control unit 68. The information acquisition unit 69 acquires control related information about the irradiation direction of the light P4 allowed to project from the lighting unit 6 into the external space S1. The first driving unit 66 and the second driving unit 67 drive the lighting unit 6. The control unit 68 changes, in accordance with the control related information acquired by the information acquisition unit 69, the irradiation direction of the light P4 emerging from the lighting unit 6. The control unit 68 changes the irradiation direction of the light P4 by having the lighting unit 6 driven by at least one of the first driving unit 66 or the second driving unit 67. This allows the lighting system 1 to change the lighting area A1 formed by the light P4 projected from the lighting unit 6 toward the external space S1. Changing the irradiation direction includes changing the irradiation range (light beam angle).

The functions of the information acquisition unit 69 and the control unit 68 may be performed by a computer system. The computer system may include, for example, one or more input/output interfaces, one or more memories, and one or more processors (microprocessors). That is to say, the one or more processors may perform the functions of the information acquisition unit 69 and the control unit 68 by executing one or more programs (applications) stored in the one or more memories. In this embodiment, the program is stored in advance in the memory of the control unit 68. Alternatively, the program may also be downloaded via a telecommunications line such as the Internet or distributed after having been recorded in a non-transitory storage medium such as a memory card. Note that the input/output interface is an interface for inputting and outputting information to/from the control unit 68 and includes a communications interface. The computer system performing the functions of the information acquisition unit 69 and the control unit 68 may be disposed in, for example, the lighting unit 6.

The control related information includes location information, detected by a sensor, about the location of a human being H10 who is present as a target to irradiate in the external space S1. The sensor is an imaging sensor 161 for detecting the human being H10 present in the external space S1. The imaging sensor 161 may be mounted, for example, on the ceiling 101 that faces the external space S1. The imaging sensor 161 may be, for example, a thermal imaging sensor including a plurality of pixels, each of which includes an infrared detector implemented as a thermopile. The imaging sensor 161 may generate, based on the thermal image, location information about the location of the human being H10 in the external space S1. Depending on a facility, a plurality of imaging sensors 161 may be provided for a single external space S1. In that case, identification information (address) is set on an individual basis for each imaging sensor 161. Note that the imaging sensor 161 does not have to be a thermal imaging sensor but may also be an imaging sensor including a camera to shoot the external space S1. The image sensor included in the camera may be, for example, a complementary metal-oxide semiconductor (CMOS) image sensor. However, the image sensor does not have to be a CMOS image sensor but may also be, for example, a charge-coupled device (CCD) image sensor or an infrared image sensor, for example.

The control unit 68 may store, in accordance with the location information of the lighting unit 6, the location information of the imaging sensor 161, and the detection area of the imaging sensor 161, and other pieces of information, the location information of the lighting unit 6 and location information of a plurality of small detection areas corresponding one to one to the plurality of pixels of the imaging sensor 161 in association with each other in a memory of the control unit 68.

Also, in this lighting system 1f, the control related information also includes device location information, transmitted from a transmitter device 162 in the external space S1, about the location of the transmitter device 162. The transmitter device 162 may be, for example, a remote controller or a smartphone. The control unit 68 controls the first driving unit 66 to change the irradiation direction of the light P4 in accordance with the device location information transmitted from the transmitter device 162. The transmitter device 162 transmits a wireless signal including the device location information when operated, for example, by the human being H10 present in the external space S1. The information acquisition unit 69 includes a reception unit to receive the wireless signal transmitted from the transmitter device 162 and acquires the device location information via the reception unit.

In the lighting system 1f according to the sixth embodiment, the control unit 68 changes the irradiation direction of the light P4 emerging from the lighting unit 6 in accordance with the control related information acquired by the information acquisition unit 69, thus enabling changing the lighting area A1.

Optionally, the lighting system 1f may also be configured to make the information acquisition unit 69 acquire identification information of the human being H10 as another piece of the control related information and to make the control unit 68 control the adjustment unit 10 based on the identification information and the location information to irradiate the human being H10 with light, of which the chromaticity is adjusted to his or her preference. The adjustment unit 10 gives control signals to the driver circuits for the first light source unit 11 and the second light source units 12 (i.e., the first and second driver circuits), thereby adjusting the output powers of respective laser light sources of the first light source unit 11 and the second light source units 12. This allows the lighting system 1f to irradiate the human being H10 with the light P4, of which the chromaticity is adjusted to his or her preference.

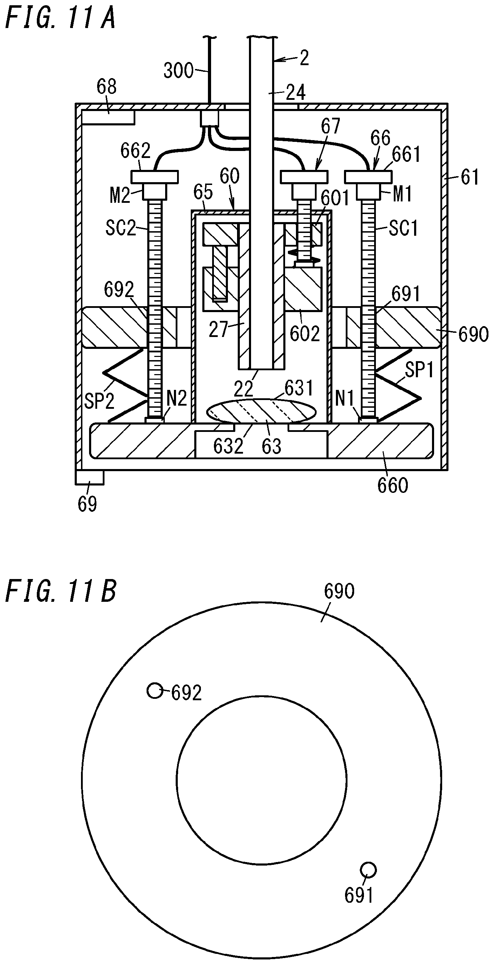

As shown in FIG. 11, the lighting unit 6 includes a lighting unit body 61 having the shape of a bottomed cylinder and a light projection unit 60 which is arranged in the lighting unit body 61 to project, toward the external space, the light P4 emerging from the light emerging portion 22 of the optical fiber 2. The light projection unit 60 includes: a ferrule 27 covering an end portion, including the light emerging portion 22, of the optical fiber 2; a lens 63 facing the light emerging portion 22 of the optical fiber 2; a protective member 65 housing the lens 63 and the ferrule 27 therein; a ringlike frame member 690 arranged in the lighting unit body 61 to surround the protective member 65; and a flange portion 660 protruding outward from a tip portion of the protective member 65. The lens 63 may be a biconvex lens, for example. The lens 63 is arranged on the optical axis of the light emerging portion 22 of the optical fiber 2 to be out of contact with the light emerging portion 22. The lens 63 has a first lens surface 631 facing the light emerging portion 22 of the optical fiber 2 and a second lens surface 632 opposite from the first lens surface 631. In the light projection unit 60, the second lens surface 632 of the lens 63 is exposed. The light projection unit 60 is movable inside the lighting unit body 61. The frame member 690 is fixed to the lighting unit body 61.

In this lighting system 1f, the first driving unit 66 serves as a driving unit for driving the (light projection unit 60 of the) lighting unit 6 to change the irradiation direction of the light P4. Also, in this lighting system 1f, the second driving unit 67 serves as a driving unit for driving the (light projection unit 60 of the) lighting unit 6 to change the distance between the light emerging portion 22 of the optical fiber 2 and the lens 63.

The first driving unit 66 includes a first actuator 661 and a second actuator 662.

The first actuator 661 includes a first motor M1, a first feed screw SC1, a first nut N1, and a first spring SP1. In the first actuator 661, one end portion of the first feed screw SC1 is coupled to the rotary shaft of the first motor M1 and the other end portion of the first feed screw SC1 is fitted into the first nut N1. The first nut N1 is in contact with the flange portion 660 of the light projection unit 60. The first spring SP1 is interposed between the frame member 690 and the flange portion 660 and is stretchable and shrinkable in the direction aligned with the axis of the first feed screw SC1. The first feed screw SC1 is fitted into a first screw hole 691 of the frame member 690 between the first motor M1 and the flange portion 660. In the first driving unit 66, the first motor M1 is movable, when rotating, along the axis of the first feed screw SC1. The axis of the first feed screw SC1 is substantially parallel to the axis of the lighting unit body 61.

The second actuator 662 includes a second motor M2, a second feed screw SC2, a second nut N2, and a second spring SP2. In the second actuator 662, one end portion of the second feed screw SC2 is coupled to the rotary shaft of the second motor M2 and the other end portion of the second feed screw SC2 is fitted into the second nut N2. The second nut N2 is in contact with the flange portion 660 of the light projection unit 60. The second spring SP2 is interposed between the frame member 690 and the flange portion 660 and is stretchable and shrinkable in the direction aligned with the axis of the second feed screw SC2. The second feed screw SC2 is fitted into a second screw hole 692 of the frame member 690 between the second motor M2 and the flange portion 660. In the first driving unit 66, the second motor M2 is movable, when rotating, along the axis of the second feed screw SC2. The axis of the second feed screw SC2 is substantially parallel to the axis of the lighting unit body 61.

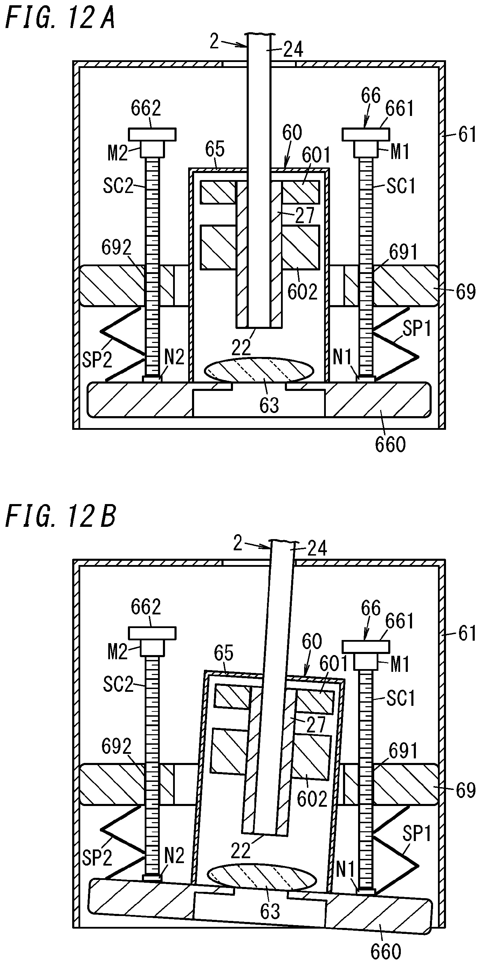

In this lighting system 1f, the control unit 68 controls the first motor M1 and second motor M2 of the first driving unit 66. In the lighting system 1f, as the first feed screw SC1 is driven downward from the state shown in FIG. 12A, for example, by rotating the first motor M1 in a first rotational direction, the flange portion 660 is driven downward so as to tilt around the point of contact between the flange portion 660 and the second nut N2 as a fulcrum and thereby cause the optical axis of the light emerging portion 22 of the optical fiber 2 to tilt with respect to the axis of the first feed screw SC1 and the longitudinal axis of the lighting unit body 61. As a result, the irradiation direction of the light P4 changes. In addition, the lighting system 1f may recover the state shown in FIG. 12A by rotating, in the state shown in FIG. 12B, the first motor M1 in a second rotational direction opposite from the first rotational direction. Furthermore, in the lighting system 1f, as the second feed screw SC2 is driven downward from the state shown in FIG. 12A, for example, by rotating the second motor M2 in the first rotational direction, the flange portion 660 is driven downward so as to tilt around the point of contact between the flange portion 660 and the first nut N1 as a fulcrum and thereby cause the optical axis of the light emerging portion 22 of the optical fiber 2 to tilt with respect to the axis of the second feed screw SC2 and the longitudinal axis of the lighting unit body 61. As a result, the irradiation direction of the light P4 also changes.

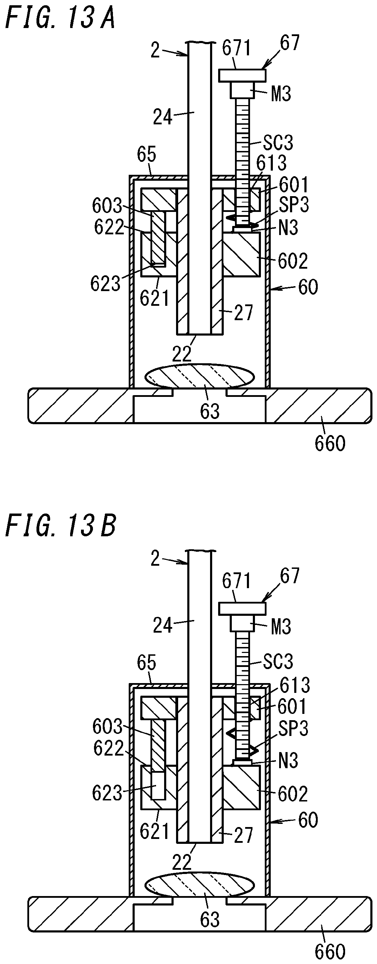

As shown in FIGS. 13A and 13B, the second driving unit 67 includes a third actuator 671. The third actuator 671 includes a third motor M3, a third feed screw SC3, a third nut N3, and a third spring SP3. In the lighting unit 6, the light projection unit 60 includes a fixed frame member 601 and a moving frame member 602 which are arranged in the protective member 65. The fixed frame member 601 is fixed to the protective member 65. The moving frame member 602 is spaced from the fixed frame member 601 in the direction aligned with the optical axis of the optical fiber 2 and is movable to change the distance from the fixed frame member 601. The optical fiber 2 is not fixed to the fixed frame member 601 but is fixed to the moving frame member 602. This allows the optical fiber 2 to move along with the moving frame member 602. In this lighting system 1f, the fixed frame member 601, the moving frame member 602, the light emerging portion 22, and the lens 63 are arranged in this order in the direction aligned with the optical axis of the optical fiber 2. In the third actuator 671, one end portion of the third feed screw SC3 is coupled to the rotary shaft of the third motor M3 and the other end portion of the third feed screw SC3 is fitted into the third nut N3. The third nut N3 is in contact with the moving frame member 602. The third spring SP3 is interposed between the fixed frame member 601 and the moving frame member 602 and is stretchable and shrinkable in the direction aligned with the axis of the third feed screw SC3. The fixed frame member 601 further includes a screw 613 into which the third feed screw SC3 is fitted. The lighting unit 6 further includes a supporting pin 603 protruding from the fixed frame member 601 toward the moving frame member 602. The moving frame member 602 has a first principal surface 621 facing the lens 63 and a second principal surface 622 facing the fixed frame member 601. The second principal surface 622 has a recess 623 into which the supporting pin 603 is fitted.

In the lighting system 1f according to the sixth embodiment, the control unit 68 controls the third motor M3 of the second driving unit 67. In this lighting system 1f, as the third feed screw SC3 is driven downward as shown in FIG. 13B by rotating the third motor M3 in the first direction from the state shown in FIG. 13A, for example, the moving frame member 602 is driven downward to change the distance between the light emerging portion 22 of the optical fiber 2 and the lens 63. Also, the lighting system 1f may recover the state shown in FIG. 13A by rotating, in the state shown in FIG. 13B, the third motor M3 in a second rotational direction opposite from the first rotational direction.

In the lighting system 1f according to the sixth embodiment, the control unit 68 changes, in accordance with the control related information, the distance between the light emerging portion 22 of the optical fiber 2 and the lens 63. Also, in this lighting system 1f, the control unit 68 control the second driving unit 67 to change the distance between the light emerging portion 22 of the optical fiber 2 and the lens 63 as shown in FIGS. 13A and 13B. This allows the lighting system 1f to change the light beam angle of the light P4 emerging from the lighting unit 6 to irradiate the external space S1. That is to say, the lighting system 1f enables changing the spread of the lighting area A1 by changing the distance between the light emerging portion 22 of the optical fiber 2 and the lens 63.

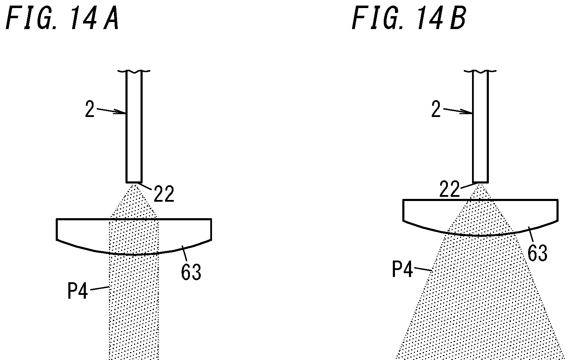

In the lighting system 1f according to a first variation of the sixth embodiment, the lens 63 of the lighting unit 6 may also be a plano-convex lens as shown in FIGS. 14A and 14B. In the lens 63, the planar surface of the plano-convex lens constitutes a first lens surface 631 of the first lens 63 and the convex curved surface of the plano-convex lens constitutes a second lens surface 632 of the first lens 63. The lighting system 1f according to the first variation of the sixth embodiment enables changing the spread of the lighting area A1 by changing the distance between the light emerging portion 22 of the optical fiber 2 and the lens 63. FIG. 14A illustrates the relative arrangement of the optical fiber 2 and the lens 63 and the distribution of the light P4 in a situation where the distance between the light emerging portion 22 of the optical fiber 2 and the lens 63 is equal to the focal length of the lens 63. FIG. 14B illustrates the relative arrangement of the optical fiber 2 and the lens 63 and the distribution of the light P4 in a situation where the distance between the light emerging portion 22 of the optical fiber 2 and the lens 63 is shorter than the focal length of the lens 63.

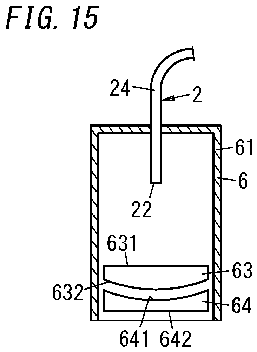

In the lighting system 1f according to a second variation of the sixth embodiment, the lighting unit 6 may further include a second lens 64, which is disposed inside the lighting unit body 61 and located opposite from the light emerging portion 22 with respect to the lens 63 (hereinafter referred to as a "first lens 63") as shown in FIG. 15. The second lens 64 is arranged on the optical axis of the light emerging portion 22 to be out of contact with the first lens 63. The distance between the light emerging portion 22 of the optical fiber 2 and the second lens 64 is longer than the distance between the light emerging portion 22 and the first lens 63.

The first lens 63 has the first lens surface 631 facing the light emerging portion 22 of the optical fiber 2 and the second lens surface 632 opposite from the first lens surface 631. The first lens 63 may be, for example, a plano-convex lens that performs a condensing function. In the first lens 63, the planar surface of the plano-convex lens constitutes the first lens surface 631 of the first lens 63 and the convex curved surface of the plano-convex lens constitutes the second lens surface 632 of the first lens 63. On the other hand, the second lens 64 is a plano-concave lens with the capability of reducing an axial chromatic aberration, for example. The second lens 64 has a first lens surface 641 facing the first lens 63 and a second lens surface 642 opposite from the first lens surface 641. In the second lens 64, the concave curved surface of the plano-concave lens constitutes the first lens surface 641 of the second lens 64 and the planar surface of the plano-concave lens constitutes the second lens surface 642 of the second lens 64. The lighting unit 6 does not have to include both the first lens 63 and the second lens 64. Alternatively, the lighting unit 6 may also include at least one of the first lens 63 or the second lens 64. Still alternatively, the lighting unit 6 may include neither the first lens 63 nor the second lens 64.

Furthermore, in the lighting system 1f according to a third variation of the sixth embodiment, the coupler 167 may include a motor for turning the lighting unit 6 from a first position to a second position, or vice versa, around a single rotational axis that intersects at right angles with the axis of the arm 166. The motor controls the angle of rotation of the lighting unit 6 around the rotational axis. The motor is driven by a third driving unit. In the lighting system 1f according to the third variation, the third driving unit may be arranged in the fixed portion 165 and connected to the motor via an electric wire. The lighting system 1f according to the third variation may also adjust the irradiation direction of the light P4 emerging from the lighting unit 6 by making the control unit 68 control the third driving unit.

### (Other variations)

Note that the first to sixth embodiments described above are only exemplary ones of various embodiments of the present disclosure and should not be construed as limiting. Rather, the first to sixth exemplary embodiments may be readily modified in various manners depending on a design choice or any other factor without departing from the scope of the present disclosure.

For example, in the optical fiber 2, the number of the wavelength-converting portion(s) 23 provided between the light incident portion 21 and the light emerging portion 22 does not have to be one but may also be multiple, for example. In the latter case, the plurality of wavelength-converting portions 23 are arranged side by side along the optical axis of the core 3.

In the embodiments described above, the core 3 includes the first core portion 3A and the second core portion 3B. However, the core 3 needs to include at least the first core portion 3A. In other words, the wavelength-converting portion 23 does not have to be provided for only a part of the length of the optical fiber 2 but may be provided for the entire length of the optical fiber 2 as well.

The laser light source included in the first light source unit 11 does not have to be a semiconductor laser diode that emits a blue laser beam but may also be, for example, a semiconductor laser diode that emits a violet laser beam. Furthermore, the first light source unit 11 does not have to include the semiconductor laser diode but may have a configuration including, for example, a light-emitting diode (LED) light source and an optical system.

The second light source unit 121 does not have to be a semiconductor laser diode that emits a green laser beam but may also be an LED that emits a green light ray. The second light source unit 122 does not have to be a semiconductor laser diode that emits a red laser beam but may also be an LED that emits a red light ray.

Furthermore, the lighting systems 1, 1a, 1b, 1c, 1d, 1e, 1f each include a plurality of second light source units 12. However, this is only an example and should not be construed as limiting. Rather, the lighting system 1, 1a, 1b, 1c, 1d, 1e, 1f only needs to include at least one second light source unit 12.

If the protective cover 7 has flexibility, the protective cover 7 may be flexible along the entire length thereof but may also be flexible in at least a part of its length. The protective cover 7 may be configured to have flexibility using a bellows structure, for example. Alternatively, the protective cover 7 may also be configured to have flexibility using a woven structure.

The adjustment unit 10 only needs to adjust the intensity of seed light P2 having at least one wavelength among the plurality of seed light rays P2. The adjustment unit 10 may be, for example, a liquid crystal filter which is disposed on an optical path of the seed light P2 between the second light source unit 12 and the light incident portion 21 of the optical fiber 2 and which may adjust the transmittance of the seed light P2.

Furthermore, the target to irradiate does not have to be a human being H10 but may also be an animal, an artwork, a plant, a piece of furniture, or a structure, for example.

### (Aspects)

The first to sixth embodiments and their variations described above may be specific implementations of the following aspects of the present disclosure.

Alighting system (1; 1a; 1b; 1c; 1d; 1e; 1f) according to a first aspect includes an optical fiber (2), a first light source unit (11), a second light source unit (12), and a lighting unit (6). The optical fiber (2) includes a light incident portion (21), a light emerging portion (22), and a wavelength-converting portion (23). The wavelength-converting portion (23) is provided between the light incident portion (21) and the light emerging portion (22). The wavelength-converting portion (23) contains a wavelength-converting element, which is excited by excitation light (P1) and amplifies a spontaneous emission of light, having a longer wavelength than the excitation light (P1), with an amplified spontaneous emission of light. The first light source unit (11) makes the excitation light (P1) incident on the light incident portion (21). The second light source unit (12) makes seed light (P2) incident on the light incident portion (21). The seed light (P2) causes the wavelength-converting element excited by the excitation light (P1) and the amplified spontaneous emission of light to produce a stimulated emission of light (P3). The lighting unit (6) projects, into an external space (S1), light emerging from the light emerging portion (22) of the optical fiber (2).

The lighting system (1; 1a; 1b; 1c; 1d; 1e; 1f) according to the first aspect enables increasing the intensity of light (stimulated emission of light P3) having a different wavelength from the excitation light (P1). Note that the optical fiber (2) includes a wavelength-converting portion (23) containing a wavelength-converting element as described above. The wavelength-converting element may be excited by excitation light (P1) to produce a spontaneous emission of light having a longer wavelength than the excitation light (P1) and may also be excited by an amplified spontaneous emission of light. The first light source unit (11) makes the excitation light (P1) incident on the optical fiber (2). The second light source unit (12) makes seed light (P2) incident on the optical fiber (2). The seed light (P2) causes the wavelength-converting element excited by either the excitation light (P1) or the amplified spontaneous emission of light to produce a stimulated emission of light (P3).

In a lighting system (1; 1a; 1b; 1c; 1d; 1e; 1f) according to a second aspect, which may be implemented in conjunction with the first aspect, the first light source unit (11) includes a laser light source.

The lighting system (1; 1a; 1b; 1c; 1d; 1e; 1f) according to the second aspect enables increasing the intensity of the excitation light (P1).

A lighting system (1b; 1c; 1d; 1e; 1f) according to a third aspect, which may be implemented in conjunction with the first or second aspect, further includes a protective cover (7). The protective cover (7) covers the wavelength-converting portion (23) at least partially.

The lighting system (1b; 1c; 1d; 1e; 1f) according to the third aspect allows the protective cover (7) to protect the wavelength-converting portion (23) at least partially.

In a lighting system (1b; 1c; 1d; 1e; f) according to a fourth aspect, which may be implemented in conjunction with the third aspect, a space (8) is left between the protective cover (7) and the wavelength-converting portion (23).

The lighting system (1b; 1c; 1d; 1e; 1f) according to the fourth aspect makes it easier to dissipate the heat generated by the wavelength-converting portion (23).

In a lighting system (1b; 1d; 1f) according to a fifth aspect, which may be implemented in conjunction with the third or fourth aspect, a gap (9) is left between the protective cover (7) and the first light source unit (11) and the second light source unit (12).

The lighting system (1b; 1d; 1f) according to the fifth aspect makes it easier to dissipate the heat generated by the wavelength-converting portion (23).

In a lighting system (1b; 1c; 1d; 1e; 1f) according to a sixth aspect, which may be implemented in conjunction with any one of the third to fifth aspects, at least a part of the protective cover (7) has flexibility.

The lighting system (1b; 1c; 1d; 1e; 1f) allows the optical fiber (2) and the protective cover (7) to be installed with an increased degree of freedom.

In a lighting system (1; 1a; 1b; 1c; 1d; 1e; 1f) according to a seventh aspect, which may be implemented in conjunction with any one of the first to sixth aspects, part of the optical fiber (2) is hidden behind a structure (e.g., a ceiling 101) that holds the lighting unit (6).

The lighting system (1; 1a; 1b; 1c; 1d; 1e; 1f) may make the optical fiber (2) invisible from the external space (S1).

A lighting system (1e; 1f) according to an eighth aspect, which may be implemented in conjunction with any one of the first to seventh aspects, includes a plurality of the optical fibers (2). At least two optical fibers (2), out of the plurality of the optical fibers (2), are bundled together and held by the lighting unit (6).

The lighting system (1e; 1f) may increase the quantity of the light emerging from the lighting unit (6) while reducing an increase in the overall size of the lighting unit (6).

A lighting system (1f) according to a ninth aspect, which may be implemented in conjunction with any one of the first to eighth aspects, further includes an information acquisition unit (69), a driving unit (first driving unit 66), and a control unit (68). The information acquisition unit (69) acquires control related information about an irradiation direction of the light (P4) to project from the lighting unit (6) into the external space (S1). The driving unit (first driving unit 66) drives the lighting unit (6). The control unit (68) changes, in accordance with the control related information acquired by the information acquisition unit (69), an irradiation direction of light (P4) emerging from the lighting unit (6).

The lighting unit (1f) according to the ninth aspect may change the lighting area (A1) by changing the irradiation direction of the light (P4) emerging from the lighting unit (6).

In a lighting system (1f) according to a tenth aspect, which may be implemented in conjunction with the ninth aspect, the control related information includes location information detected by a sensor (such as an imaging sensor 161) about a location of a target to irradiate (e.g., a human being H10) in the external space (S1).

The lighting system (1f) according to the tenth aspect enables changing the irradiation direction of the light (P4) emerging from the lighting unit (6) in accordance with the location information of the target to irradiate (e.g., a human being H10).

In a lighting system (1f) according to an eleventh aspect, which may be implemented in conjunction with the tenth aspect, the target to irradiate is a human being (H10). The sensor is an imaging sensor (161) that detects the human being (H10) present in the external space (S1).

The lighting system (1f) according to the eleventh aspect enables changing the irradiation direction of the light (P4) emerging from the lighting unit (6) according to the location of the human being (H10) present in the external space (S1).

In a lighting system (1f) according to a twelfth aspect, which may be implemented in conjunction with any one of the ninth to eleventh aspects, the control related information includes device location information transmitted from a transmitter device (162) in the external space (S1) about a location of the transmitter device (162). The control unit (68) controls the lighting unit (6) to change the irradiation direction of the light (P4) in accordance with the device location information.

The lighting system (1f) according to the twelfth aspect enables changing the irradiation direction of the light (P4) emerging from the lighting unit (6) according to the location of the transmitter device (162).

In a lighting system (1f) according to a thirteenth aspect, which may be implemented in conjunction with any one of the ninth to twelfth aspects, the control unit (68) changes the irradiation direction of the light (P4) by having the lighting unit (6) driven by the driving unit (first driving unit 66).

The lighting system (1f) according to the thirteenth aspect enables changing the irradiation direction of the light (P4) by making the control unit (68) control the driving unit (first driving unit 66).

In a lighting system (1f) according to a fourteenth aspect, which may be implemented in conjunction with any one of the ninth to thirteenth aspects, the lighting unit (6) includes: a lighting unit body (61) holding the optical fiber (2); and a lens (63) arranged in the lighting unit body (61) to control distribution of the light (P4) emerging from the light emerging portion (22). The lens (63) is arranged on the optical axis of the light emerging portion (22) of the optical fiber (2) to be out of contact with the light emerging portion (22) and controls the distribution of the light (P4) emerging from the light emerging portion (22). The control unit (68) changes, in accordance with the control related information, a distance between the light emerging portion (22) and the lens (63).

The lighting system (1f) according to the fourteenth aspect enables changing the light beam angle of the light (P4) emerging from the lighting unit (6) to irradiate the external space (S 1).

In a lighting system (1f) according to a fifteenth aspect, which may be implemented in conjunction with any one of the ninth to thirteenth aspects, the lighting unit (6) includes: a lighting unit body (61) holding the optical fiber (2); a first lens (63) arranged in the lighting unit body (61) to face the light emerging portion (22); and a second lens (64) arranged in the lighting unit body (61) to be located opposite from the light emerging portion (22) with respect to the first lens (63).

The lighting system (1f) according to the fifteenth aspect allows the first lens (63) and the second lens (64) to respectively perform two different functions, e.g., enables making the first lens (63) perform a condensing function and the second lens (64) perform the function of reducing the axial chromatic aberration.

In a lighting system (1e) according to a sixteenth aspect, which may be implemented in conjunction with any one of the first to fifteenth aspects, the lighting unit (6) further includes: a lighting unit body (61) holding the optical fiber (2); and a reflector (62) arranged in the lighting unit body (61) to reflect, toward the external space (S 1), at least a part of the light (P4) emerging from the light emerging portion (22) of the optical fiber (2).

The lighting system (1e) according to the sixteenth aspect enables controlling the distribution of the light using the reflector (62).

In a lighting system (1; 1a; 1b; 1c; 1d; 1e; 1f) according to a seventeenth aspect, which may be implemented in conjunction with any one of the first to sixteenth aspects, the wavelength-converting element includes an element selected from the group consisting of Pr, Tb, Ho, Dy, Er, Eu, Nd, and Mn.

The lighting system (1; 1a; 1b; 1c; 1d; 1e; 1f) according to the seventeenth aspect enables, when the wavelength-converting element includes two or more elements, for example, excitation caused by the amplified spontaneous emission of light from at least one element to produce an amplified spontaneous emission of light from another element at a different wavelength.

Alighting system (1; 1a; 1b; 1c; 1d; 1e; 1f) according to an eighteenth aspect, which may be implemented in conjunction with any one of the first to seventeenth aspects, includes a plurality of the second light source units (12). The plurality of the second light source units (12) respectively emit multiple rays of the seed light (P21, P22). The multiple rays of the seed light (P21, P22) respectively emitted from the plurality of the second light source units (12) have mutually different wavelengths.

The lighting system (1; 1a; 1b; 1c; 1d; 1e; 1f) according to the eighteenth aspect allows light (P4), including multiple stimulated emissions of light (P3) corresponding one to one to the multiple rays of the seed light (P21, P22), to emerge from the light emerging portion (22).

Alighting system (1; 1a; 1b; 1c; 1d; 1e; 1f) according to a nineteenth aspect, which may be implemented in conjunction with any one of the first to eighteenth aspects, further includes an adjustment unit (10) that adjusts intensity of the seed light (P2).

The lighting system (1; 1a; 1b; 1c; 1d; 1e; 1f) according to the nineteenth aspect enables adjusting the chromaticity of the light (P4) emerging from the light emerging portion (22) of the optical fiber (2).

### Reference Signs List

- 1, 1a, 1b, 1c, 1d, 1e, 1f: Lighting System
- 2: Optical Fiber
- 21: Light Incident Portion
- 22: Light Emerging Portion
- 23: Wavelength-Converting Portion
- 6: Lighting unit
- 61: Lighting unit body
- 62: Reflector
- 63: Lens (First Lens)
- 64: Second Lens
- 66: First Driving Unit (Driving Unit)
- 67: Second Driving Unit
- 68: Control Unit
- 69: Information Acquisition Unit
- 7: Protective Cover
- 8: Space
- 9: Gap
- 10: Adjustment Unit
- 11: First Light Source Unit
- 12: Second Light Source Unit
- 121: Second Light Source Unit
- 122: Second Light Source Unit
- 101: Ceiling (Structure)
- 161: Imaging Sensor
- 162: Transmitter Device
- H10: Human Being
- P1: Excitation Light
- P2: Seed Light
- P21: Seed Light Ray
- P22: Seed Light Ray
- P3: Stimulated Emission of Light
- P4: Light
- S1: External Space

## Claims

1. A lighting system comprising:
an optical fiber including a light incident portion, a light emerging portion, and a wavelength-converting portion, the wavelength-converting portion being provided between the light incident portion and the light emerging portion and containing a wavelength-converting element, the wavelength-converting element being excited by excitation light and amplifying a spontaneous emission of light, having a longer wavelength than the excitation light, with an amplified spontaneous emission of light;
a first light source unit configured to make the excitation light incident on the light incident portion;
a second light source unit configured to make seed light incident on the light incident portion, the seed light causing the wavelength-converting element that has been excited by the excitation light and the amplified spontaneous emission of light to produce a stimulated emission of light; and
a lighting unit configured to project, into an external space, light emerging from the light emerging portion of the optical fiber.

2. The lighting system of claim 1, wherein
the first light source unit includes a laser light source.

3. The lighting system of claim 1 or 2, further comprising a protective cover that covers the wavelength-converting portion at least partially.

4. The lighting system of claim 3, wherein
a space is left between the protective cover and the wavelength-converting portion.

5. The lighting system of claim 3 or 4, wherein
a gap is left between the protective cover and the first light source unit and the second light source unit.

6. The lighting system of any one of claims 3 to 5, wherein
at least a part of the protective cover has flexibility.

7. The lighting system of any one of claims 1 to 6, wherein
part of the optical fiber is hidden behind a structure configured to hold the lighting unit.

8. The lighting system of any one of claims 1 to 7, wherein
the lighting system includes a plurality of the optical fibers, and
at least two optical fibers, out of the plurality of the optical fibers, are bundled together and held by the lighting unit.

9. The lighting system of any one of claims 1 to 8, further comprising:
an information acquisition unit configured to acquire control related information about an irradiation direction of the light to project from the lighting unit into the external space;
a driving unit configured to drive the lighting unit; and
a control unit configured to change, in accordance with the control related information acquired by the information acquisition unit, an irradiation direction of light emerging from the lighting unit.

10. The lighting system of claim 9, wherein
the control related information includes location information detected by a sensor about a location of a target to irradiate in the external space.

11. The lighting system of claim 10, wherein
the target to irradiate is a human being, and
the sensor is an imaging sensor configured to detect the human being present in the external space.

12. The lighting system of any one of claims 9 to 11, wherein
the control related information includes device location information transmitted from a transmitter device in the external space about a location of the transmitter device, and
the control unit is configured to control the driving unit to change the irradiation direction of the light in accordance with the device location information.

13. The lighting system of any one of claims 9 to 12, wherein
the control unit is configured to change the irradiation direction of the light by having the lighting unit driven by the driving unit.

14. The lighting system of any one of claims 9 to 13, wherein
the lighting unit includes:
a lighting unit body holding the optical fiber; and
a lens arranged in the lighting unit body to control distribution of the light emerging from the light emerging portion, and
the control unit is configured to change, in accordance with the control related information, a distance between the light emerging portion and the lens.

15. The lighting system of any one of claims 9 to 13, wherein
the lighting unit includes:
a lighting unit body holding the optical fiber;
a first lens arranged in the lighting unit body to face the light emerging portion; and
a second lens arranged in the lighting unit body to be located opposite from the light emerging portion with respect to the first lens.

16. The lighting system of any one of claims 1 to 15, wherein
the lighting unit further includes a reflector configured to reflect, toward the external space, at least a part of the light emerging from the light emerging portion of the optical fiber.

17. The lighting system of any one of claims 1 to 16, wherein
the wavelength-converting element includes an element selected from the group consisting of Pr, Tb, Ho, Dy, Er, Eu, Nd, and Mn.

18. The lighting system of any one of claims 1 to 17, wherein
the lighting system includes a plurality of the second light source units,
the plurality of the second light source units respectively emit multiple rays of the seed light, and
the multiple rays of the seed light respectively emitted from the plurality of the second light source units have mutually different wavelengths.

19. The lighting system of any one of claims 1 to 18, further comprising an adjustment unit configured to adjust intensity of the seed light.
